# EUROPÄISCHE PATENTSCHRIFT

(11) **EP 2 442 119 B1**
(45) Veröffentlichungstag und Bekanntmachung des Hinweises auf die Patenterteilung: **31.03.2021**
(21) Anmeldenummer: 11184336.3
(22) Anmeldetag: 07.10.2011
(51) Int. Cl.: G01R 31/00, G01R 31/34

(54) **Verfahren und elektrische Schaltung zum Testen eines an ein elektrisches Energieversorgungsnetz anschließbaren Energieerzeugers oder Energieverbrauchers**
Method and electric circuit for testing an energy generator or energy consumer which can be attached to an electrical energy supply network
Procédé et circuit électrique destinés à tester un générateur d'énergie ou un consommateur d'énergie pouvant être raccordé à un réseau d'alimentation en énergie électrique

(30) Priorität: 14.10.2010 DE 102010048541
(43) Veröffentlichungstag der Anmeldung: 18.04.2012
(73) Patentinhaber: GE Energy Power Conversion GmbH, 12277 Berlin (DE)
(72) Erfinder: Niesel, Norbert, 13359 Berlin (DE); Janning, Jörg, 12559 Berlin (DE)
(74) Vertreter: Serjeants LLP

(56) Entgegenhaltungen:
- EP-A1- 2 146 264
- DE-A1-102008 049 629
- CHUNG Y H ET AL: "Voltage Sag and Swell Generator with Thyristor Controlled Reactor", POWER SYSTEM TECHNOLOGY, 2002. PROCEEDINGS. POWERCON 2002. INTERNATIONAL CONFERENC, PISCATAWAY, NJ, USA,IEEE, 1. Januar 2002 (2002-01-01), Seiten 1933-1937, XP008094733, DOI: 10.1109/ICPST.2002.1067870
- WESSELS C ET AL: "Transformer based voltage sag generator to perform LVRT and HVRT tests in the laboratory", POWER ELECTRONICS AND MOTION CONTROL CONFERENCE (EPE/PEMC), 2010 14TH INTERNATIONAL, IEEE, PISCATAWAY, NJ, USA, 6. September 2010 (2010-09-06), Seiten T11-8, XP031778570, ISBN: 978-1-4244-7856-9

## Beschreibung

Die Erfindung betrifft ganz allgemein ein Verfahren und eine elektrische Schaltung zum Testen eines an ein elektrisches Energieversorgungsnetz anschließbaren Energieerzeugers oder Energieverbrauchers. Bei den Energieerzeugern und Energieverbrauchern kann es sich um Generatoren, Motoren, Brennstoffzellen, Solar-Wechselrichter, sogenannte Power Conditioning Systeme oder sonstige elektrische Komponenten handeln, die an ein Energieversorgungsnetz angeschlossen werden können.

Insbesondere betrifft die Erfindung ein Verfahren und eine elektrische Schaltung zum Testen eines Generators einer Windkraftanlage. Es versteht sich, dass die Erfindung auch bei einem Wasserkraftwerk oder bei einem Gasheizkraftwerk oder dergleichen zur Anwendung kommen kann.

Zur Erzeugung elektrischer Energie sind Windkraftanlagen bekannt, bei denen ein Generator mit Hilfe eines dem Wind ausgesetzten Windrads angetrieben wird. Die erzeugte elektrische Energie wird dann in ein Energieversorgungsnetz eingespeist.

Von den Betreibern der Energieversorgungsnetze sind Bedingungen aufgestellt worden, die eine Windkraftanlage erfüllen muss, damit sie an das Energieversorgungsnetz angeschlossen werden darf. Eine sogenannte fault-ride-through-Bedingung macht es dabei erforderlich, dass die Windkraftanlage auch im Falle einer Überhöhung der Spannung des Energieversorgungsnetzes weiterhin in der Lage ist, elektrische Energie in das Energieversorgungsnetz einzuspeisen.

Es ist bekannt, dass diejenigen elektrischen Bauteile, die der Erzeugung elektrischer Energie dienen, also insbesondere der Generator und gegebenenfalls zugehörige Umrichter, separat, also unabhängig von der Windkraftanlage, mit Hilfe von elektrischen Simulationsschaltungen geprüft werden. Beispielsweise kann eine Windsimulation mit Hilfe eines Elektromotors realisiert sein, mit der ein erwünschter Wind simuliert wird, und die dann auf den Generator einwirkt. Weiterhin kann eine Netzsimulation vorhanden sein, die ein Energieversorgungsnetz simuliert, in das der Generator die erzeugte elektrische Energie einspeist. Diese Netzsimulation ist elektrisch mit dem Generator oder den zugehörigen Umrichtern verbunden. Die Netzsimulation kann derart beeinflusst werden, dass ein erwünschter Spannungsverlauf des Energieversorgungsnetzes mit einer einstellbaren Frequenz erzeugt und dem Generator vorgegeben werden kann.

Die bekannten Verfahren und elektrischen Schaltungen sind in der Lage, einen Spannungseinbruch auf Null, also einen Kurzschluss des Energieversorgungsnetzes zu simulieren. Eine Spannungsüberhöhung kann jedoch nicht simuliert werden. Weitere relevante Dokumente aus dem Stand der Technik sind EP 2 146 264 A1, DE 10 2008 049629 A1 und CHUNG Y H ET AL: "Voltage Sag and Swell Generator with Thyristor Controlled Reactor", XP008094733.

Der Erfindung ist damit die Aufgabe gestellt, ein Verfahren und eine elektrische Schaltung zu schaffen, mit denen beliebige Spannungsüberhöhungen mit beliebigen Frequenzen frei eingestellt werden können.

Die Erfindung löst diese Aufgabe durch die Verfahren nach den Ansprüchen 1 und 6. Die Erfindung löst diese Aufgabe ebenfalls durch elektrische Schaltungen nach den Ansprüchen 4 und 8.

Bei einer ersten Ausführungsform der Erfindung ist der Energieerzeuger oder Energieverbraucher an einen Anschlusspunkt angeschlossen. Eine Umrichterschaltung ist vorhanden, mit der eine an dem Anschlusspunkt anliegende Spannung beeinflussbar ist. Die Umrichterschaltung ist über einen Transformator mit dem Anschlusspunkt verbunden. Es ist eine Serienschaltung vorhanden, die aus einer Drosselspule und einem ersten Schalter aufgebaut ist, und die mit dem Anschlusspunkt verbunden ist. In zeitlich aufeinander abgestimmter Weise wird zuerst der erste Schalter geschlossen und die Umrichterschaltung derart beeinflusst, dass die Spannung an dem Anschlusspunkt einen erwünschten Wert aufweist, und es wird der erste Schalter danach geöffnet.

Die Spannungsüberhöhung des simulierten Energieversorgungsnetzes wird durch das Zusammenspiel mehrerer Maßnahmen erzeugt. So wird durch das Schließen des ersten Schalters ein Spannungseinbruch an dem Anschlusspunkt hervorgerufen. Diesem Spannungseinbruch wird durch eine entsprechende Beeinflussung der Umrichterschaltung entgegengewirkt. Das nachfolgende Öffnen des ersten Schalters führt dann zu einer Erhöhung der Spannung an dem Anschlusspunkt.

Diese Vorgehensweise bringt den Vorteil mit sich, dass ohne einen wesentlichen zusätzlichen Aufwand eine simulierte Spannungsüberhöhung auf einfache Weise erreicht werden kann. Das Testen des Energieerzeugers oder Energieverbrauchers kann damit wesentlich vereinfacht und verbessert werden.

Bei einer zweiten Ausführungsform der Erfindung ist der Energieerzeuger oder Energieverbraucher an einen Anschlusspunkt angeschlossen, an dem eine Spannung anliegt. Es ist eine Serienschaltung vorhanden, die aus einer Drosselspule und einem ersten Schalter aufgebaut ist, und die mit dem Anschlusspunkt verbunden ist. Es ist eine Parallelschaltung vorhanden, die aus einer Drosselspule und einem zweiten Schalter aufgebaut ist, und die mit dem Anschlusspunkt verbunden ist. Die Serienschaltung ist mit einer Spannung beaufschlagt wird, die größer ist als die Spannung an dem Anschlusspunkt. In zeitlich abgestimmter Weise wird einerseits der erste Schalter geschlossen, so dass die Spannung an dem Anschlusspunkt ansteigt, und andererseits wird der zweite Schalter geöffnet.

Die Spannungsüberhöhung des simulierten Verbrauchers wird durch das Schließen des ersten Schalters und das Öffnen des zweiten Schalters erreicht. Durch das Schließen des ersten Schalters gelangt die die Serienschaltung beaufschlagende Spannung an den Anschlusspunkt und führt dort zu einem Spannungsanstieg. Durch das Öffnen des zweiten Schalters wird erreicht, dass sich eine erhöhte Spannung an dem Anschlusspunkt ausbilden kann.

Diese Vorgehensweise bringt den Vorteil mit sich, dass mit einem geringen Aufwand eine simulierte Spannungsüberhöhung erreicht werden kann. Ein weiterer Vorteil der vorliegenden Ausführungsform der Erfindung besteht darin, dass hier keine Umrichterschaltung zwingend erforderlich ist. Das Testen des Energieerzeugers oder Energieverbrauchers kann damit wesentlich vereinfacht und verbessert werden.

Bei einer Ausgestaltung der Erfindung ist eine Umrichterschaltung vorhanden, die mit der Parallelschaltung verbunden ist, und mit der die an dem Anschlusspunkt anliegende Spannung beeinflussbar ist. In zeitlich aufeinander abgestimmter Weise wird einerseits der erste Schalter geschlossen und andererseits die Umrichterschaltung derart beeinflusst, dass die Spannung an dem Anschlusspunkt auf einen erhöhten Wert übergeht. Mit Hilfe der Umrichterschaltung kann die Art und Weise des Übergangs der Spannung an dem Anschlusspunkt auf die erhöhte Spannung beeinflusst werden.

Bei einer Weiterbildung der Erfindung ist/sind der/die Schalter als elektronische/s Leistungshalbleiterbauelement/e ausgebildet, beispielsweise als Thyristor mit oder ohne zugehörige Löschschaltung oder als GTO-Thyristor (GTO = gate-turn-off) oder als ausschaltbarer IGBT (IGBT = insulated gate bipolar transistor). Dies bringt den Vorteil mit sich, dass der Zeitpunkt der Betätigung des/der Schalter besonders einfach und genau kontrolliert werden kann. Insbesondere kann der Einsatz von Thyristoren ohne Löschschaltung vorteilhaft sein, da diese das Verhalten eines Mittelspannungsschalters relativ realistisch nachbilden.

Bei einer anderen Weiterbildung der Erfindung ist/sind die Induktivität/en der Drosselspule/n einstellbar. Damit können gleichartige Spannungseinbrüche bei unterschiedlichen Frequenzen des simulierten Energieversorgungsnetzes erreicht werden.

Weitere Merkmale, Anwendungsmöglichkeiten und Vorteile der Erfindung ergeben sich aus der nachfolgenden Beschreibung von Ausführungsbeispielen der Erfindung, die in den Figuren der Zeichnung dargestellt sind. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung sowie unabhängig von ihrer Formulierung bzw. Darstellung in der Beschreibung bzw. in der Zeichnung.

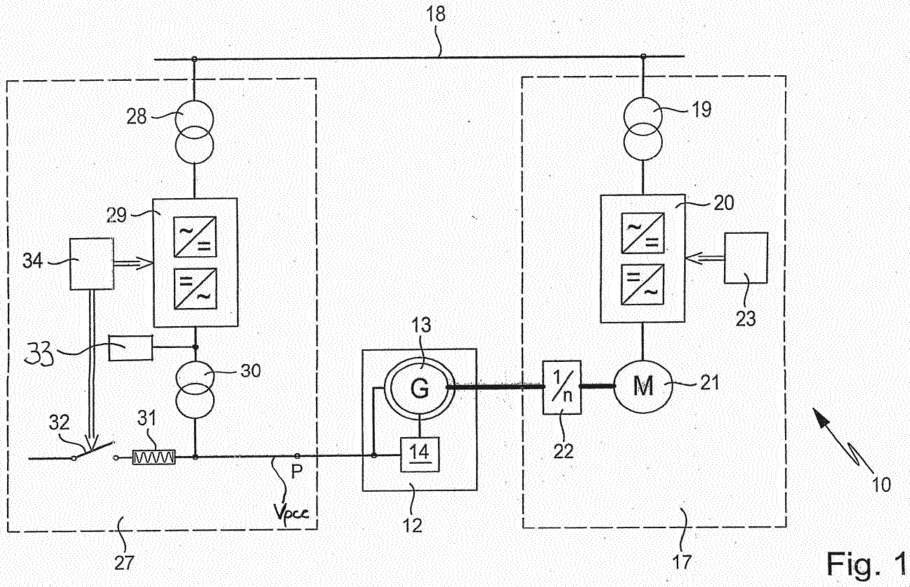

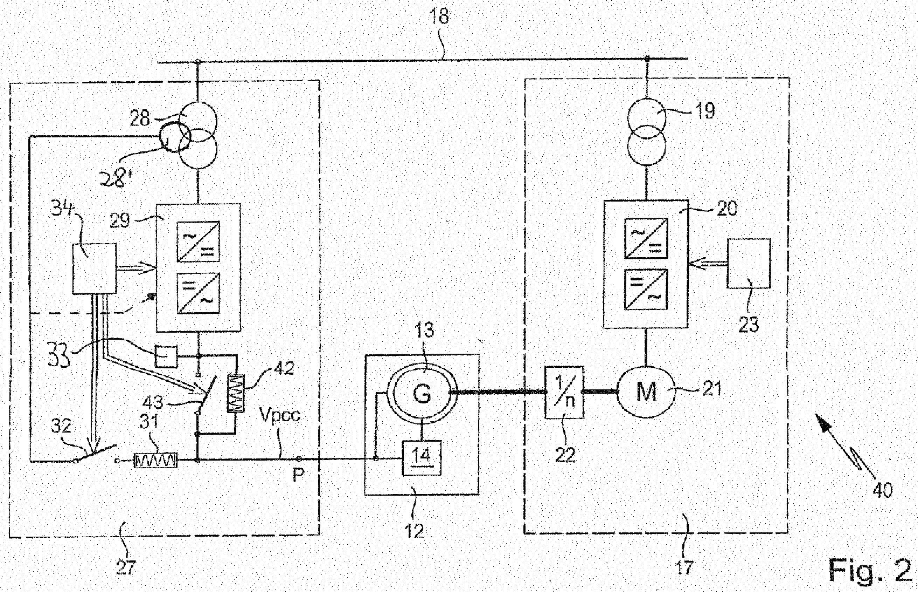

Figur 1 zeigt ein schematisches Blockschaltbild eines ersten Ausführungsbeispiels einer erfindungsgemäßen elektrischen Schaltung zum Testen eines Generators insbesondere einer Windkraftanlage, und Figur 2 zeigt ein schematisches Blockschaltbild eines zweiten Ausführungsbeispiels einer entsprechenden elektrischen Schaltung.

In der Figur 1 ist eine elektrische Schaltung 10 dargestellt, die im vorliegenden Ausführungsbeispiel im Zusammenhang mit einer Windkraftanlage zum Einsatz kommt. Es versteht sich, dass die Schaltung 10 auch bei einem Wasserkraftwerk oder bei einem Gasheizkraftwerk oder dergleichen zur Anwendung kommen kann. Weiterhin ist die Schaltung 10 im vorliegenden Ausführungsbeispiel zum Testen eines Generators vorgesehen. Es versteht sich, dass auch andere Energieerzeuger oder Energieverbraucher mit der Schaltung 10 getestet werden können, beispielsweise können auch ein Elektromotor oder eine Brennstoffzelle oder ein Solar-Wechselrichter oder ein sogenanntes Power Conditioning System oder dergleichen getestet werden.

Die Schaltung 10 ist in der Figur 1 zum Zwecke der Vereinfachung im Wesentlichen nur einphasig dargestellt. Es versteht sich, dass die Schaltung 10 auch zwei- und mehrphasig ausgebildet sein kann.

Die Schaltung 10 weist eine Generatorschaltung 12 auf, die getestet werden soll. Bei der Generatorschaltung 12 handelt es sich um diejenigen Bauteile der Windkraftanlage, die der Erzeugung elektrischer Energie dienen. Im vorliegenden Ausführungsbeispiel ist die Generatorschaltung 12 beispielhaft aus einem doppelt-gespeisten Asynchrongenerator 13 mit zugehörigen Umrichtern 14 aufgebaut. Der Rotor des Asynchrongenerators 13 ist über die Umrichter mit einem Anschlusspunkt der Generatorschaltung 12 verbunden und der Stator des Asynchrongenerators 13 ist direkt mit diesem Anschlusspunkt verbunden. Es versteht sich, dass auch andere Generator-Typen zur Anwendung kommen können, beispielsweise Synchrongeneratoren, und/oder dass auch keine Umrichter vorhanden sein können.

Die Schaltung 10 weist eine Windsimulation 17 auf, die im vorliegenden Ausführungsbeispiel den den Asynchrongenerator 13 antreibenden Wind simulieren soll. Die Windsimulation 17 ist aus einem an ein Energieversorgungsnetz 18 angeschlossenen Transformator 19, einer Umrichterschaltung 20 und einem Elektromotor 21 aufgebaut. Die Antriebswelle des Elektromotors 21 ist über ein gegebenenfalls zwischengeschaltetes Getriebe 22 drehfest mit der Antriebswelle des Generators 13 verbunden.

Mit Hilfe einer Steuerung und/oder Regelung 23 kann die Umrichterschaltung 20 derart über der Zeit beeinflusst werden, dass der resultierende Drehzahlverlauf des Elektromotors 21 einem erwünschten, den Asynchrongenerator 13 antreibenden Wind entspricht.

Die elektrische Schaltung 10 muss örtlich nicht direkt bei der Windkraftanlage aufgebaut sein, sondern kann unabhängig von der Windkraftanlage beispielsweise in einer Versuchshalle untergebracht sein. Es versteht sich aber, dass die Schaltung 10 auch direkt bei der Windkraftanlage vorhanden sein kann. Ist in diesem Fall die Generatorschaltung 12 in die Windkraftanlage eingebaut, ist also insbesondere der Asynchrongenerator 13 drehfest mit dem Windrad der Windkraftanlage verbunden, so kann die Windsimulation 17 ersatzlos entfallen.

Die elektrische Schaltung 10 weist eine Netzsimulation 27 auf, die den zeitlichen Spannungsverlauf eines simulierten Energieversorgungsnetzes simulieren soll. In dieses simulierte Energieversorgungsnetz speist die Generatorschaltung 12 elektrische Energie ein. Die Netzsimulation 27 ist aus einem an das Energieversorgungsnetz 18 angeschlossenen Transformator 28, einer Umrichterschaltung 29 und einem weiteren Transformator 30 aufgebaut. Die Umrichterschaltung 29 ist über den weiteren Transformator 30 mit der Generatorschaltung 12 verbunden, im vorliegenden Ausführungsbeispiel mit dem erwähnten Anschlusspunkt der Generatorschaltung 12. Ausgehend von diesem Anschlusspunkt der Generatorschaltung 12 ist auf der Verbindung zu dem Transformator 30 ein weiterer Anschlusspunkt P vorhanden, an dem eine Spannung Vpcc anliegt (pcc = point of common coupling).

Insbesondere bei einer geeigneten Auslegung der Umrichterschaltung 29 kann der weitere Transformator 30 alternativ auch durch eine Drosselspule ersetzt werden. Dies ist insbesondere dann besonders kostengünstig, wenn das Übersetzungsverhältnis des Transformators 30 nicht benötigt wird.

Alternativ ist es weiterhin möglich, dass zwischen den beiden Umrichterschaltungen 20, 29 der Windsimulation 17 und der Netzsimulation 27 eine gemeinsame Gleichspannungsschiene vorhanden ist. In diesem Fall ist nur ein einziger netzseitiger Umrichter und nur ein einziger Transformator in Richtung zu dem Energieversorgungsnetz 18 hin erforderlich.

An den Anschlusspunkt P ist eine Serienschaltung einer Drosselspule 31 und eines ersten Schalters 32 angeschlossen. Die Reihenfolge innerhalb der Serienschaltung ist dabei unerheblich, so dass auch der Schalter 32 an den Anschlusspunkt P angeschlossen sein kann. Die Serienschaltung kann an einen Sternpunkt mehrerer Phasen angeschlossen sein. Ebenfalls ist es möglich, dass die Serienschaltung ein Bestandteil einer Dreieckschaltung mehrerer Phasen ist. Gegebenenfalls kann die Serienschaltung auch nach Masse geschaltet sein.

Weiterhin ist zwischen der Umrichterschaltung 29 und dem Transformator 30 eine Filterschaltung 33 angeschlossen.

Die Induktivität der Drosselspule 31 ist veränderbar. Dies kann beispielsweise dadurch erreicht werden, dass die Anzahl der Windungen der Drosselspule 31 mittels mechanischer Vorrichtungen manuell einstellbar ist. Mit Hilfe entsprechender Einstellungen der Drosselspule 31 können im wesentlichen gleichartige Verläufe des simulierten Energieversorgungsnetzes erzeugt werden, und zwar unabhängig von der Frequenz des simulierten Energieversorgungsnetzes.

Der erste Schalter 32 ist als elektronisches Leistungshalbleiterbauelement ausgebildet. Beispielsweise kann es sich bei dem Schalter 32 um einen Thyristor mit oder ohne zugehörige Löschschaltung oder um einen GTO-Thyristor (GTO = gate-turn-off) oder um einen ausschaltbaren IGBT (IGBT = insulated gate bipolar transistor) oder dergleichen handeln, wobei diese Bauelemente vorzugsweise als Module aufgebaut sein können und damit beispielsweise Freilaufdioden und dergleichen bereits enthalten können.

Bei der Filterschaltung 33 kann es sich um bekannte elektrische Schaltungen handeln, mit deren Hilfe die Spannung Vpcc geglättet werden kann.

Mit Hilfe einer Steuerung und/oder Regelung 34 kann die Umrichterschaltung 29 derart über der Zeit beeinflusst werden, dass der resultierende zeitliche Verlauf der Spannung Vpcc einem erwünschten vorgegebenen Spannungsverlauf eines Energieversorgungsnetzes entspricht. Die vorgegebenen Spannungsverläufe können dabei symmetrisch oder asymmetrisch eingestellt sein. Es können auch unterschiedliche Frequenzen des simulierten Energieversorgungsnetzes mittels der Umrichterschaltung 29 frei eingestellt werden, insbesondere 50 Hertz und 60 Hertz.

Weiterhin ist die Steuerung und/oder Regelung 34 dazu vorgesehen, den Schalter 32 von einem geschlossenen in einen geöffneten Zustand und umgekehrt zu schalten. Nachfolgend wird davon ausgegangen, dass sich der Schalter 32 in seinem geöffneten Zustand befindet und die Drosselspule 31 damit nicht wirksam ist.

Insgesamt kann eine zu testende Generatorschaltung 12 mittels der Windsimulation 17 einem erwünschten Wind und mittels der Netzsimulation 27 einem vorgegebenen Spannungsverlauf des gespeisten Energieversorgungsnetzes ausgesetzt werden. Die elektrische Schaltung 10 ist damit unter anderem dazu geeignet, das Verhalten der Generatorschaltung 12 bei einer einphasigen oder mehrphasigen Überhöhung der Spannung des gespeisten Energieversorgungsnetzes auf eine vorgegebene Überspannung zu testen.

Bei geöffnetem Schalter 32 wird mit Hilfe der Umrichterschaltung 29 die Spannung Vpcc auf einen erwünschten Wert für die Spannung des gespeisten Energieversorgungsnetzes eingestellt.

Zur Simulation einer Spannungsüberhöhung des gespeisten Energieversorgungsnetzes werden von der Netzsimulation 27 zwei Maßnahmen in zeitlich aufeinander abgestimmter Weise durchgeführt. Zuerst wird der erste Schalter 32 in seinen geschlossenen Zustand geschaltet, so dass die Spannung Vpcc über der Drosselspule 31 anliegt. Dies führt an sich zu einem Spannungseinbruch der Spannung Vpcc, der jedoch von der Umrichterschaltung 29 dadurch ausgeglichen wird, dass die Spannung Vpcc weiterhin auf den erwünschten Wert für die Spannung des gespeisten Energieversorgungsnetzes gesteuert oder geregelt wird. Danach wird der Schalter 32 in seinen geöffneten Zustand geschaltet. Dies hat eine Erhöhung der Spannung Vpcc zur Folge. Die auf diese Weise erreichbare Überspannung ist dabei unter anderem von der an dem Transformator 30 anliegenden Spannung abhängig. Der Verlauf und der Umfang der Spannungsüberhöhung kann zusätzlich von der Umrichterschaltung 29 beeinflusst oder unterstützt werden.

Die genannten Maßnahmen werden nicht gleichzeitig durchgeführt, sondern laufen in einem weitgehend zusammenfallenden Zeitbereich ab. Wesentlich ist die zeitliche Abstimmung der beiden Maßnahmen derart zueinander, dass der Übergang zu der angestrebten Spannungsüberhöhung des simulierten und von der Generatorschaltung 12 gespeisten Energieversorgungsnetzes den erwünschten Verlauf hat.

Durch die erläuterten Maßnahmen kann - wie erwähnt - eine Erhöhung auf eine vorgegebene Überspannung in demjenigen Energieversorgungsnetz simuliert werden, in das die Generatorschaltung 12 elektrische Energie einspeist. Es kann damit getestet werden, wie sich die Generatorschaltung 12 in einem derartigen Fall verhält. Insbesondere kann geprüft werden, ob die Generatorschaltung 12 sogenannte fault-ride-through-Bedingungen erfüllt.

Zur Beendigung der simulierten Spannungsüberhöhung in dem Energieversorgungsnetz werden die beiden erläuterten Maßnahmen von der Netzsimulation 27 wieder rückgängig gemacht. Auch hier kommt es nicht auf die Gleichzeitigkeit oder die Reihenfolge der Maßnahmen an, sondern auf deren zeitliche Abstimmung zueinander. Beispielsweise kann die Umrichterschaltung 29 derart beeinflusst werden, dass die Spannung Vpcc wieder auf den an sich erwünschten Wert für die Spannung des gespeisten Energieversorgungsnetzes zurückgeht. Dieser Übergang kann durch ein vorübergehendes Schließen des ersten Schalters 32 unterstützt werden.

In der Figur 2 ist eine elektrische Schaltung 40 dargestellt, die auf der Schaltung 10 der Figur 1 aufgebaut ist. Im Hinblick auf die mit der Schaltung 10 übereinstimmenden Bauteile der Schaltung 40 wird auf die vorstehende Erläuterung der Figur 1 verwiesen. Nachfolgend werden nur diejenigen Bauteile und Funktionen der Schaltung 40 der Figur 2 näher erläutert, die sich von der Schaltung 10 der Figur 1 unterscheiden.

In Ergänzung zur Schaltung 10 der Figur 1 enthält die Schaltung 40 der Figur 2 eine Parallelschaltung einer Drosselspule 42 und eines zweiten Schalters 43. Weiterhin weist der Transformator 28 eine zusätzliche Wicklung 28' auf, die mit dem Schalter 32 verbunden ist. Die Übersetzung der zusätzlichen Wicklung 28' zu der Primärwicklung des Transformators 28 ist dabei derart gewählt, dass die Spannung an dieser Wicklung 28' größer ist als der an sich als Spannung Vpcc vorgesehene, erwünschte Wert für die Spannung des simulierten Energieversorgungsnetzes.

Im Unterschied zur Schaltung 10 der Figur 1 weist die Schaltung 40 der Figur 2 keinen weiteren Transformator 30 auf. Es wird darauf hingewiesen, dass der weitere Transformator 30 der Figur 1 als solcher auch bei der Schaltung 40 der Figur 2 vorhanden sein kann.

Die vorgenannte Parallelschaltung der Drosselspule 42 und des zweiten Schalters 43 ist zwischen die Umrichterschaltung 29 und den Anschlusspunkt P geschaltet. Sofern der weitere Transformator 30 vorhanden ist, dann ist die Parallelschaltung zwischen diesen weiteren Transformator 30 und den Anschlusspunkt P geschaltet. Der weitere Transformator 30 kann aber auch zwischen den Anschlusspunkt P und die genannte Parallelschaltung geschaltet sein.

Die Induktivität der Drosselspule 42 ist veränderbar. Dies kann beispielsweise dadurch erreicht werden, dass die Anzahl der Windungen der Drosselspule 42 mittels mechanischer Vorrichtungen manuell einstellbar ist.

Der zweite Schalter 43 ist als elektronisches Leistungshalbleiterbauelement ausgebildet. Beispielsweise kann es sich bei dem Schalter 43 um einen Thyristor mit einer zugehörigen Löschschaltung oder um einen GTO-Thyristor (GTO = gate-turn-off) oder um einen ausschaltbaren IGBT (IGBT = insulated gate bipolar transistor) oder dergleichen handeln, wobei diese Bauelemente vorzugsweise als Module aufgebaut sein können und damit beispielsweise Freilaufdioden und dergleichen bereits enthalten können.

Weiterhin ist die Steuerung und/oder Regelung 34 dazu vorgesehen, den zweiten Schalter 43 von einem geschlossenen in einen geöffneten Zustand und umgekehrt zu schalten. Nachfolgend wird davon ausgegangen, dass der Schalter 32 sich in seinem geöffneten Zustand und der Schalter 43 sich in seinem geschlossenen Zustand befindet. Damit sind beide Drosselspulen 31, 42 unwirksam.

Zur Simulation einer Spannungsüberhöhung des gespeisten Energieversorgungsnetzes werden von der Netzsimulation 27 drei Maßnahmen in zeitlich aufeinander abgestimmter Weise durchgeführt. So wird einerseits der zweite Schalter 43 geöffnet und andererseits die Umrichterschaltung 29 derart beeinflusst, dass die Spannung Vpcc mit einem erwünschten Übergangsverhalten auf die erwünschte vorgegebene Überspannung übergeht. Weiterhin wird der erste Schalter 32 in seinen geschlossenen Zustand geschaltet, so dass die Spannung der Wicklung 28' des Transformators 28 über die Drosselspule 31 an dem Anschlusspunkt P anliegt. Die erwünschte Überspannung ist damit unter anderem von der an der Wicklung 28' des Transformators 28 vorhandenen Spannung abhängig. Die drei Maßnahmen müssen nicht gleichzeitig durchgeführt werden, sondern laufen in einem weitgehend zusammenfallenden Zeitbereich ab. Die Reihenfolge der genannten Maßnahmen steht dabei nicht im Vordergrund. Wesentlich ist die zeitliche Abstimmung der drei Maßnahmen derart zueinander, dass der Übergang zu der angestrebten Spannungsüberhöhung des simulierten und von der Generatorschaltung 12 gespeisten Energieversorgungsnetzes den erwünschten Verlauf hat.

Beispielsweise werden die drei Maßnahmen derart zueinander synchronisiert, dass zuerst der zweite Schalter 43 geöffnet und dann der Schalter 32 geschlossen wird, um danach die Spannung Vpcc mit Hilfe der Umrichterschaltung 29 derart zu beeinflussen, dass sie auf die vorgegebene Überspannung übergeht. Zumindest werden die drei Maßnahmen derart zeitlich abgestimmt, dass das Öffnen des Schalters 43 in einem Zeitraum erfolgt, bevor eine Spannungsüberhöhung der Spannung Vpcc simuliert wird.

Ergänzend wird darauf hingewiesen, dass während der vorstehend erläuterten Maßnahmen die Beeinflussung der Umrichterschaltung 29 möglichst phasensynchron zu derjenigen Spannung vorgenommen wird, die an der Wicklung 28' des Transformators 28 anliegt. Dies ist in der Figur 2 mit Hilfe eines gestrichelten Pfeils angedeutet.

Es ist auch möglich, die Umrichterschaltung 29 zur Simulation der Spannungsüberhöhung des gespeisten Energieversorgungsnetzes wegzulassen, wenn auf eine Feinabstimmung des Spannungsverlaufs verzichtet werden kann oder verzichtet werden soll. Der Transformator 28 ist in diesem Fall mit der erläuterten Parallelschaltung direkt verbunden. Beispielsweise kann in diesem Fall zuerst der zweite Schalter 43 geöffnet und dann der Schalter 32 geschlossen werden. Die erhöhte Spannung der Wicklung 28' des Transformators 28 liegt dann über die Drosselspule 31 an dem Anschlusspunkt P an.

Durch die erläuterten Maßnahmen kann - wie erwähnt - eine Überhöhung der Spannung in demjenigen Energieversorgungsnetz simuliert werden, in das die Generatorschaltung 12 elektrische Energie einspeist. Es kann damit getestet werden, wie sich die Generatorschaltung 12 in diesen Fällen verhält. Insbesondere kann geprüft werden, ob die Generatorschaltung 12 die bereits erwähnten fault-ride-through-Bedingungen erfüllt.

Zur Beendigung der simulierten Spannungsüberhöhung in dem Energieversorgungsnetz werden die drei erläuterten Maßnahmen von der Netzsimulation 27 rückgängig gemacht. Auch hier kommt es nicht auf die Gleichzeitigkeit oder die Reihenfolge der Maßnahmen an, sondern auf deren zeitlichen Abstimmung zueinander. Beispielsweise wird zuerst der erste Schalter 32 geöffnet und dann der zweite Schalter 43 in seinen geschlossenen Zustand geschaltet, um danach die Umrichterschaltung 29 derart zu beeinflussen, dass die Spannung Vpcc wieder auf einen erwünschten Wert abfällt.

## Patentansprüche

1. Verfahren für eine Netzsimulation (27) zum Testen eines an ein elektrisches Energieversorgungsnetz anschließbaren Energieerzeugers oder Energieverbrauchers, wobei der Energieerzeuger oder Energieverbraucher an einen Anschlusspunkt (P) angeschlossen ist, und wobei eine Umrichterschaltung (29) vorhanden ist, mit der eine an dem Anschlusspunkt (P) anliegende Spannung (Vpcc) beeinflussbar ist, wobei die Umrichterschaltung (29) über einen Transformator (30) oder eine Drosselspule mit dem Anschlusspunkt (P) verbunden ist,
**dadurch gekennzeichnet, dass**
eine Serienschaltung vorhanden ist, die aus einer Drosselspule (31) und einem ersten Schalter (32) aufgebaut ist, und die mit dem Anschlusspunkt (P) verbunden ist, dass in zeitlich aufeinander abgestimmter Weise zuerst der erste Schalter (32) geschlossen und die Umrichterschaltung (29) derart beeinflusst wird, dass die Spannung (Vpcc) an dem Anschlusspunkt (P) einen erwünschten Wert aufweist, und dass der erste Schalter (32) danach geöffnet wird;
wobei das Schließen des ersten Schalters (32) zu einem Einbruch der Spannung (Vpcc) an dem Anschlusspunkt (P) führt, und dass diesem Einbruch durch die Beeinflussung der Umrichterschaltung (29) entgegengewirkt wird; und
wobei das Öffnen des ersten Schalters (32) zu einer Erhöhung der Spannung (Vpcc) an dem Anschlusspunkt (P) führt.

2. Verfahren nach Anspruch 1, wobei die Umrichterschaltung (29) derart beeinflusst wird, dass die Spannung (Vpcc) an dem Anschlusspunkt (P) von einem erhöhten Wert auf den erwünschten Wert abfällt.

3. Verfahren nach Anspruch 2, wobei in zeitlich aufeinander abgestimmter Weise der erste Schalter (32) vorübergehend geschlossen wird.

4. Elektrische Schaltung (10) für eine Netzsimulation (27) zum Testen eines an ein elektrisches Energieversorgungsnetz anschließbaren Energieerzeugers oder Energieverbrauchers, umfassend:
einen Anschlusspunkt (P), an welchen der Energieerzeuger oder Energieverbraucher während der Netzsimulation anschließbar ist;
eine Umrichterschaltung (29), die über einen Transformator (30) oder eine Drosselspule mit dem Anschlusspunkt (P) verbunden und mit der eine an dem Anschlusspunkt (P) anliegende Spannung (Vpcc) beeinflussbar ist;
**gekennzeichnet durch**
eine Serienschaltung, die aus einer Drosselspule (31) und einem ersten Schalter (32) aufgebaut ist, und die mit dem Anschlusspunkt (P) verbunden ist; und
eine Steuerung und/oder Regelung (34), von der in zeitlich aufeinander abgestimmter Weise zuerst der erste Schalter (32) geschlossen und die Umrichterschaltung (29) derart beeinflusst wird, dass die Spannung (Vpcc) an dem Anschlusspunkt (P) einen erwünschten Wert aufweist, und von der der erste Schalter (32) danach geöffnet wird;
wobei das Schließen des ersten Schalters (32) zu einem Einbruch der Spannung (Vpcc) an dem Anschlusspunkt (P) führt, und dass diesem Einbruch durch die Beeinflussung der Umrichterschaltung (29) entgegengewirkt wird; und
wobei das Öffnen des ersten Schalters (32) zu einer Erhöhung der Spannung (Vpcc) an dem Anschlusspunkt (P) führt.

5. Elektrische Schaltung (10) nach Anspruch 4, wobei die Steuerung und/oder Regelung (34) dazu vorgesehen ist, die Umrichterschaltung (29) derart zu beeinflussen, dass die Spannung (Vpcc) an dem Anschlusspunkt (P) von einem erhöhten Wert auf den erwünschten Wert abfällt.

6. Verfahren für eine Netzsimulation (27) zum Testen eines an ein elektrisches Energieversorgungsnetz anschließbaren Energieerzeugers oder Energieverbrauchers, wobei der Energieerzeuger oder Energieverbraucher an einen Anschlusspunkt (P) angeschlossen ist, und wobei an dem Anschlusspunkt (P) eine Spannung (Vpcc) anliegt,
**dadurch gekennzeichnet, dass**
eine Serienschaltung vorhanden ist, die aus einer Drosselspule (31) und einem ersten Schalter (32) aufgebaut ist, und die mit dem Anschlusspunkt (P) verbunden ist, wobei eine Parallelschaltung vorhanden ist, die aus einer weiteren Drosselspule (42) und einem zweiten Schalter (43) aufgebaut ist, und die mit dem Anschlusspunkt (P) verbunden ist, wobei eine Umrichterschaltung (29) vorhanden ist, die mit der Parallelschaltung verbunden ist und mit der die an dem Anschlusspunkt (P) anliegende Spannung (Vpcc) beeinflussbar ist, wobei die Serienschaltung mit einer Spannung beaufschlagt wird, die größer ist als die Spannung (Vpcc) an dem Anschlusspunkt (P), und dass in zeitlich abgestimmter Weise einerseits der erste Schalter (32) geschlossen wird und die Umrichterschaltung (29) derart beeinflusst wird, so dass die Spannung (Vpcc) an dem Anschlusspunkt (P) ansteigt und auf einen erhöhten Wert übergeht, und andererseits der zweite Schalter (43) geöffnet wird.

7. Verfahren nach Anspruch 6, wobei der erste Schalter (32) geöffnet wird, so dass die Spannung (Vpcc) an dem Anschlusspunkt (P) abfällt, und wobei der zweite Schalter (43) in zeitlich abgestimmter Weise mit dem Öffnen des ersten Schalters (32) geschlossen wird.

8. Elektrische Schaltung (40) für eine Netzsimulation (27) zum Testen eines an ein elektrisches Energieversorgungsnetz anschließbaren Energieerzeugers oder Energieverbrauchers, umfassend:
einen Anschlusspunkt (P), an welchen der Energieerzeuger oder Energieverbraucher während der Netzsimulation anschließbar ist;
**gekennzeichnet durch**
eine Serienschaltung, die aus einer Drosselspule (31) und einem ersten Schalter (32) aufgebaut ist, und die mit dem Anschlusspunkt (P) verbunden ist;
eine Parallelschaltung, die aus einer weiteren Drosselspule (42) und einem zweiten Schalter (43) aufgebaut ist, und die mit dem Anschlusspunkt (P) verbunden ist;
eine Umrichterschaltung (29), die mit der Parallelschaltung verbunden ist, mit der eine an dem Anschlusspunkt (P) anliegende Spannung (Vpcc) beeinflussbar ist, wobei die Umrichterschaltung (29) an ein Energieversorungsnetz (18) durch einen Transformator (28) anschließbar ist, welcher eine zusätzliche Wicklung (28') aufweist, die mit der Serienschaltung verbunden ist, wobei die Spannung an der Wicklung (28') größer ist als die Spannung (Vpcc) an dem Anschlusspunkt (P); und
eine Steuerung und/oder Regelung (34), von der in zeitlich abgestimmter Weise einerseits der erste Schalter (32) geschlossen und die Umrichterschaltung (29) derart beeinflusst wird, so dass die Spannung (Vpcc) an dem Anschlusspunkt (P) ansteigt, und andererseits der zweite Schalter (43) geöffnet wird.

9. Elektrische Schaltung (40) nach Anspruch 8, wobei die Steuerung und/oder Regelung (34) dazu vorgesehen ist, den ersten Schalter (32) zu öffnen, so dass die Spannung (Vpcc) an dem Anschlusspunkt (P) abfällt, und den zweiten Schalter (43) in zeitlich abgestimmter Weise mit dem Öffnen des ersten Schalters (32) zu schließen.

## Claims

1. Method for a network simulation (27) for testing a power producer or power consumer connectable to an electric power grid, wherein the power producer or power consumer is connected to a terminal point (P), and wherein a converter circuit (29) is provided, by means of which voltage (Vpcc) applied to the terminal point (P) can be influenced, wherein the converter circuit (29) is connected via a transformer (30) or a choke coil to the terminal point (P),
**characterised in that**
a series connection is provided which is set up with a choke coil (31) and a first switch (32) and which is connected to the terminal point (P), **in that** in a time-coordinated manner firstly the first switch (32) is closed and the converter circuit (29) is influenced such that the voltage (Vpcc) has a desired value at the terminal point (P) and the first switch (32) is then opened;
wherein the closing of the first switch (32) leads to a drop in voltage (Vpcc) at the terminal point (P) and this drop is counteracted by the influence of the converter circuit (29); and
wherein the opening of the first switch (32) leads to an increase in voltage (Vpcc) at the terminal point (P).

2. Method according to claim 1, wherein the converter circuit (29) is influenced in such a way that the voltage (Vpcc) at the terminal point (P) drops from a raised value to the desired value.

3. Method according to claim 2, wherein the first switch (32) is temporarily closed in a time-coordinated manner.

4. Electric circuit (10) for a network simulation (27) for testing a power producer or power consumer connectable to an electric power grid, comprising:
a terminal point (P) to which the power producer or power consumer can be connected during the network simulation;
a converter circuit (29), which is connected via a transformer (30) or a choke coil to the terminal point (P) and can be influenced by the voltage (Vpcc) applied to the terminal point (P),
**characterised by**
a series connection which is set up with a choke coil (31) and a first switch (32) and which is connected to the terminal point (P); and
a control and/or regulating unit (34), by which in a time-coordinated manner firstly the first switch (32) is closed and the converter circuit (29) is influenced in such a way that the voltage (Vpcc) at the terminal point (P) has a desired value, and by which the first switch (32) is then opened;
wherein closing the first switch (32) leads to a drop in voltage (Vpcc) at the terminal point (P) and this drop is counteracted by the influence of the converter circuit (29); and
wherein opening the first switch (32) leads to an increase in voltage (Vpcc) at the terminal point (P).

5. Electric circuit (10) according to claim 4, wherein the control and/or regulating unit (34) is provided to influence the converter circuit (29) such that the voltage (Vpcc) at the terminal point (P) drops from a raised value to the desired value.

6. Method for a network simulation (27) for testing a power producer or power consumer connectable to an electric power grid, wherein the power producer or power consumer is connected to a terminal point (P), and wherein a voltage (Vpcc) is applied to the terminal point (P),
**characterised in that**
a series connection is provided which is set up with a choke coil (31) and a first switch (32), and which is connected to the terminal point (P), wherein a parallel circuit is provided, which is set up with an additional choke coil (42) and a second switch (43) and which is connected to the terminal point (P), wherein a converter circuit (29) is provided which is connected to the parallel circuit and by which the voltage (Vpcc) applied to the terminal point (P) can be influenced, wherein the series circuit is charged with voltage which is greater than the voltage (Vpcc) at the terminal point (P) and **in that** in a time-coordinated manner on the one hand the first switch (32) is closed and the converter circuit (29) is influenced in such a way that the voltage (Vpcc) at the terminal point (P) increases and transitions to a raised value and on the other hand the second switch (43) is opened.

7. Method according to claim 6, wherein the first switch (32) is opened so that the voltage (Vpcc) at the terminal point (P) drops and wherein the second switch (43) is closed in a time-coordinated manner on opening the first switch (32).

8. Electric circuit (40) for a network simulation (27) for testing a power producer or power consumer connectable to an electric power grid, comprising:
a terminal point (P) to which the power producer or power consumer can be connected during the network simulation;
**characterised by**
a series connection, which is set up with a choke coil (31) and a first switch (32), and which is connected to the terminal point (P);
a parallel connection which is set up with an additional choke coil (42) and a second switch (43) and which is connected to the terminal point (P);
a converter circuit (29) which is connected to the parallel connection by which a voltage (Vpcc) applied to the terminal point (P) can be influenced, wherein the converter circuit (29) can be connected to a power supply network (18) by a transformer (28) which has an additional winding (28') which is connected to the series circuit, wherein the voltage at the winding (28') is greater than the voltage (Vpcc) at the terminal point (P); and
a control and/or regulating unit (34) by which in a time-coordinated manner on the one hand the first switch (32) is closed and the converter circuit (29) is influenced such that the voltage (Vpcc) at the terminal point (P) increases and on the other hand the second switch (43) is opened.

9. Electric circuit (40) according to claim 8, wherein the control and/or regulating unit (34) is provided to open the first switch (32), so that the voltage (Vpcc) at the terminal point (P) decreases, and to close the second switch (43) in a time coordinated manner on opening the first switch (32).

## Revendications

1. Procédé pour une simulation de réseau (27) destiné à tester un générateur d'énergie ou un consommateur d'énergie pouvant être raccordé à un réseau d'alimentation en énergie électrique, dans lequel le générateur d'énergie ou le consommateur d'énergie est raccordé à un point de raccordement (P), et dans lequel un circuit convertisseur (29) est présent, qui permet d'influer sur une tension (Vpcc) appliquée au point de raccordement (P), dans lequel le circuit convertisseur (29) est relié au point de raccordement (P) par l'intermédiaire d'un transformateur (30) ou d'une bobine d'inductance,
**caractérisé en ce qu'**un circuit en série est présent, qui est constitué d'une bobine d'inductance (31) et d'un premier commutateur (32), et est relié au point de raccordement (P), **en ce que** de façon déterminée temporellement en fonction l'un de l'autre, tout d'abord le premier commutateur (32) est fermé et le circuit convertisseur (29) est influencé de telle sorte que la tension (Vpcc) au point de raccordement (P) présente une valeur souhaitée, et **en ce que** le premier commutateur (32) est ensuite ouvert ;
dans lequel la fermeture du premier commutateur (32) entraîne une chute de tension (Vpcc) au point de raccordement (P), et **en ce que** l'effet du circuit convertisseur (29) s'oppose à cette chute ; et
dans lequel l'ouverture du premier commutateur (32) entraîne une augmentation de la tension (Vpcc) au point de raccordement (P).

2. Procédé selon la revendication 1, dans lequel le circuit convertisseur (29) est influencé de telle sorte que la tension (Vpcc) au point de raccordement (P) diminue d'une valeur élevée à la valeur souhaitée.

3. Procédé selon la revendication 2, dans lequel, de façon déterminée temporellement en fonction l'un de l'autre, le premier commutateur (32) est fermé momentanément.

4. Circuit électrique (10) pour une simulation de réseau (27) destiné à tester un générateur d'énergie ou un consommateur d'énergie pouvant être raccordé à un réseau d'alimentation en énergie électrique, comprenant :
un point de raccordement (P) auquel le générateur d'énergie ou le consommateur d'énergie peut être raccordé pendant la simulation de réseau ;
un circuit convertisseur (29) qui est relié au point de raccordement (P) par l'intermédiaire d'un transformateur (30) ou d'une bobine d'inductance et qui permet d'influer sur une tension (Vpcc) appliquée au point de raccordement (P) ;
**caractérisé par**
un circuit en série qui est constitué d'une bobine d'inductance (31) et d'un premier commutateur (32), et est relié au point de raccordement (P) ; et
une commande et/ou un réglage (34) par lequel, de façon déterminée temporellement en fonction l'un de l'autre, tout d'abord le premier commutateur (32) est fermé et le circuit convertisseur (29) est influencé de telle sorte que la tension (Vpcc) au point de raccordement (P) présente une valeur souhaitée, et par lequel le premier commutateur (32) est ensuite ouvert ;
dans lequel la fermeture du premier commutateur (32) entraîne une chute de tension (Vpcc) au point de raccordement (P), et en ce que l'effet du circuit convertisseur (29) s'oppose à cette chute ; et
dans lequel l'ouverture du premier commutateur (32) entraîne une augmentation de la tension (Vpcc) au point de raccordement (P).

5. Circuit électrique (10) selon la revendication 4, dans lequel la commande et/ou le réglage (34) est prévu(e) pour influer sur le circuit convertisseur (29) de telle sorte que la tension (Vpcc) au point de raccordement (P) diminue d'une valeur élevée à la valeur souhaitée.

6. Procédé pour une simulation de réseau (27) destiné à tester un générateur d'énergie ou un consommateur d'énergie pouvant être raccordé à un réseau d'alimentation en énergie électrique, dans lequel le générateur d'énergie ou le consommateur d'énergie est raccordé à un point de raccordement (P), et dans lequel une tension (Vpcc) est appliquée au point de raccordement (P),
**caractérisé en ce que**
un circuit en série est présent, qui est constitué d'une bobine d'inductance (31) et d'un premier commutateur (32) et qui est relié au point de raccordement (P), dans lequel un circuit parallèle est présent, qui est constitué d'une autre bobine d'inductance (42) et d'un second commutateur (43) et qui est relié au point de raccordement (P), dans lequel un circuit convertisseur (29) est présent, qui est relié au circuit parallèle et qui permet d'influer sur une tension (Vpcc) appliquée au point de raccordement (P), dans lequel le circuit en série est alimenté par une tension qui est plus grande que la tension (Vpcc) au point de raccordement (P), et **en ce que**, de façon déterminée temporellement, d'une part le premier commutateur (32) est fermé et le circuit convertisseur (29) est influencé de telle sorte que la tension (Vpcc) augmente au point de raccordement (P) et passe à une valeur supérieure, et d'autre part le second commutateur (43) est ouvert.

7. Procédé selon la revendication 6, dans lequel le premier commutateur (32) est ouvert de sorte que la tension (Vpcc) chute au point de raccordement (P), et dans lequel le second commutateur (43) est fermé de façon déterminée temporellement avec l'ouverture du premier commutateur (32).

8. Circuit électrique (40) pour une simulation de réseau (27) destiné à tester un générateur d'énergie ou un consommateur d'énergie pouvant être raccordé à un réseau d'alimentation en énergie électrique, comprenant :
un point de raccordement (P) auquel le générateur d'énergie ou le consommateur d'énergie peut être raccordé pendant la simulation de réseau ;
**caractérisé par**
un circuit en série qui est constitué d'une bobine d'inductance (31) et d'un premier commutateur (32), et qui est relié au point de raccordement (P) ;
un circuit parallèle qui est constitué d'une autre bobine d'inductance (42) et d'un second commutateur (43) et qui est relié au point de raccordement (P) ;
un circuit convertisseur (29) qui est relié au circuit parallèle, qui permet d'influer sur une tension (Vpcc) appliquée au point de raccordement (P), dans lequel le circuit convertisseur (29) peut être raccordé à un réseau d'alimentation en énergie (18) par l'intermédiaire d'un transformateur (28) qui présente un enroulement supplémentaire (28') qui est relié au circuit en série, dans lequel la tension au niveau de l'enroulement (28') est plus grande que la tension (Vpcc) au point de raccordement (P) ; et
une commande et/ou un réglage (34) par lequel, de façon déterminée temporellement, d'une part le premier commutateur (32) est fermé et le circuit convertisseur (29) est influencé de telle sorte que la tension (Vpcc) augmente au point de raccordement (P), et d'autre part le second commutateur (43) est ouvert.

9. Circuit électrique (40) selon la revendication 8, dans lequel la commande et /ou le réglage (34) est prévu pour ouvrir le premier commutateur (32) de telle sorte que la tension (Vpcc) chute au point de raccordement (P), et pour fermer le second commutateur (43) de façon déterminée temporellement avec l'ouverture du premier commutateur (32).
